# EUROPEAN PATENT APPLICATION

(11) **EP 2 779 226 A1**
(43) Date of publication of application: **17.09.2014**
(21) Application number: 14158359.1
(22) Date of filing: 07.03.2014
(51) Int. Cl.: H01L 23/13, H01L 23/498, H01L 23/552

(54) **Apparatus for electronic assembly with improved interconnect and associated methods**

(30) Priority: 13.03.2013 US 201313802687
(71) Applicant: Altera Corporation, San Jose, CA 95134 (US)
(72) Inventor: Liu, Hui, San Jose, CA California 95134 (US); Shi, Hong, San Jose, CA California 95134 (US); Xie, Yuanlin, San Jose, CA California 95134 (US); Jiang, Xiaohong, San Jose, CA California 95134 (US)
(74) Representative: Appelt, Christian W.

(57) **Abstract**

An apparatus includes a substrate that includes electronic circuitry. The apparatus further includes a first die that includes electronic circuitry, and at least one shielded interconnect. The shielded interconnect(s) couple(s) electronic circuitry in the substrate to electronic circuitry in the first die.

## Description

### Technical Field

The disclosed concepts relate generally to electronic device or assemblies and fabrication of devices or assemblies, and more particularly to apparatus for shielded and/or coaxial coupling mechanisms or interconnects in electronic device or assemblies, and associated methods.

### Background

Advances in electronics has allowed increased levels of integration. The technology for fabrication of ICs has contributed to those advances, and has provided a vehicle for integrating a relatively large number of circuits and functions into an IC. As a result, present-day ICs might contain hundreds of millions of transistors. Notwithstanding the large number of transistors, the desired functionality of an electronic device or circuit sometimes entails using the circuitry of more than one IC. To facilitate the implementation of such functionality, sometimes two or more semiconductor die are used and coupled to one another.

As different from single chip packages, multichip packages interconnect several semiconductor die. In the case of 2D (two-dimensional) based multichip modules (MCM), chips or die are interconnected on a substrate using flip chip or wire bond interconnects. Some 3D interconnects use through silicon vias (TSVs) or plated through holes (PTHs) on either the active silicon circuit die or passive silicon substrates. As an intermediate level, 2D interconnect structures involve a silicon substrate as an interconnect substrate (known as interposer) to provide high density interconnects, using wire bond or flip chip interconnects, sometimes known as 2.5D. Flip chip interconnects may be used to provide higher interconnect density due to the area nature of the interconnect, and provide higher frequency capability due to short electrical distances. The silicon interposer entails additional costs, and there may also be longer electrical distances between the interconnected semiconductor die. As an alternative to 2.5D and the interposer, a different architecture, namely connecting the die face to face on one side of the die may be used. The face to face interconnecting of the two die can be done using either flip chip solder or copper microbumps, and connection to the outside of the 2-die stack is accomplished using wire bond.

### Summary

A variety of embodiments are contemplated for electronic apparatus with shielded and/or coaxial coupling mechanisms or interconnects, and associated techniques. In one exemplary embodiment, an apparatus includes a substrate that includes electronic circuitry. The apparatus further includes a first die that includes electronic circuitry, and at least one shielded interconnect. The shielded interconnect(s) couple(s) electronic circuitry in the substrate to electronic circuitry in the first die.

According to another exemplary embodiment, a method of fabricating a device includes fabricating a substrate that includes circuitry, and fabricating at least one die above the substrate, where the at least one die also includes circuitry. The method further includes fabricating at least one shielded interconnect to couple circuitry in the substrate to circuitry in the at least one die.

According to another exemplary embodiment, a method of fabricating a shielded interconnect in an electronic assembly includes fabricating a substrate for the electronic assembly, and fabricating at least one die above the substrate. The method further includes fabricating one conductor to couple the substrate to the at least one die, fabricating a dielectric encompassing the that conductor, and fabricating another conductor encompassing the dielectric, and couple the substrate to the at least one die.

### Brief Description of the Drawings

The appended drawings illustrate only exemplary embodiments and therefore should not be considered as limiting its scope. Persons of ordinary skill in the art appreciate that the disclosed concepts lend themselves to other equally effective embodiments. In the drawings, the same numeral designators used in more than one drawing denote the same, similar, or equivalent functionality, components, or blocks.
Fig. 1 illustrates a device or package with shielded and/or coaxial interconnect or coupling mechanism according to an exemplary embodiment.
Fig. 2 shows another device or package with shielded and/or coaxial interconnect or coupling mechanism according to an exemplary embodiment.
Fig. 3 depicts another device or package with shielded and/or coaxial interconnect according to an exemplary embodiment.
Fig. 4 illustrates a cross-section of a shielded interconnect or coupling mechanism according to an exemplary embodiment.
Fig. 5 shows a cross-section of a shielded interconnect or coupling mechanism according to an exemplary embodiment.
Fig. 6 depicts fabrication of a device with shielded and/or coaxial interconnect or coupling mechanism according to an exemplary embodiment.
Fig. 7 illustrates further fabrication of a device with shielded and/or coaxial interconnect or coupling mechanism according to an exemplary embodiment.
Fig. 8 depicts further fabrication of a device with shielded and/or coaxial interconnect or coupling mechanism according to an exemplary embodiment.
Fig. 9 shows a block diagram of a field-programmable gate array (FPGA) that may be used in exemplary embodiments.
Fig. 10 illustrates a flow diagram for a method of fabricating a device according to an exemplary embodiment.
Fig. 11 depicts a flow diagram for a method of fabricating a shielded interconnect in an electronic assembly according to an exemplary embodiment.

### Detailed Description

The disclosed concepts relate generally to electronic device or assemblies and fabrication of devices or assemblies, and associated methods. More particularly, such devices or assemblies use shielded and/or coaxial coupling mechanisms or interconnects. As described below in detail, using shielded and/or coaxial coupling mechanisms or interconnects provides a number of advantages, such as higher speeds of communication and/or frequency of operation, better noise immunity, improved isolation, better damping (e.g., if used for power distribution), lower loss, increased interconnect density, etc.

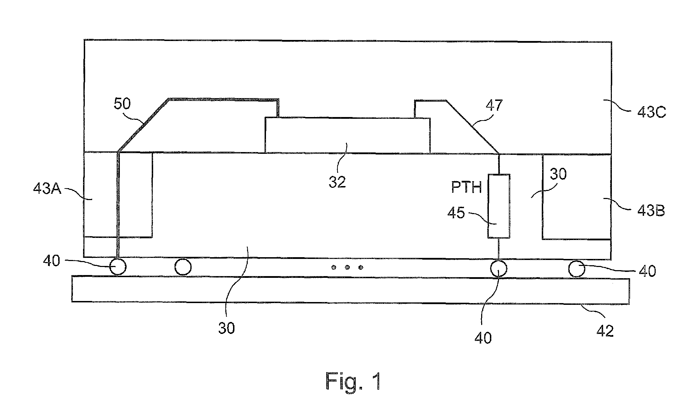

Fig. 1 illustrates a device or package with shielded interconnect according to an exemplary embodiment. Specifically, the device in Fig. 1 includes semiconductor die 32 disposed on or above a substrate 30. Although Fig. 1 shows one semiconductor die 32, in some embodiments more than one semiconductor die may be used. For example, in some embodiments, more than one semiconductor die 32 (e.g., 32A, 32B, etc.) may be used. Depending on the respective sizes of the die, circuit complexity, available technology, etc., other arrangements and/or other numbers of die may be used in other embodiments, as desired.

Generally speaking, semiconductor die 32 may include a wide variety of circuitry and/or devices, as desired. Such circuitry may include analog circuitry, digital circuitry, and mixed-signal circuitry. In some embodiments, substrate 30 may include circuitry such as various coupling mechanisms or interconnects (as described below in detail, e.g., PTHs). Generally speaking, however, substrate 30 may include a wide variety of circuitry and/or devices, as desired. Such circuitry may include analog circuitry, digital circuitry, and mixed-signal circuitry.

Circuitry in semiconductor die 32 may be coupled to circuitry in substrate 30 via one or more bond wires 47. Bond wires 47 provide a coupling mechanism between circuitry in die 32 and circuitry in substrate 30.

In addition to bond wires 47, the device in Fig. 1 includes one or more shielded coupling mechanism or interconnects 50. Shielded interconnects 50 provide a coupling path between circuitry in die 32 and circuitry in substrate 30. As described below in detail, the shielded nature of interconnects 50 provides a number of advantages over bond wires.

In some embodiments, bond wires may be used to communicate signals and/or distribute power between die 32 and substrate 30. Shielded interconnects 50 may be used to communicate signals and/or distribute or route power between die 32 and substrate 30.

Substrate 30 may include a variety of coupling mechanism or interconnects. Referring to the exemplary embodiment in Fig. 1, substrate 30 includes one or more PTH 45 to allow circuitry in die 32 to couple to circuitry in substrate 30. In addition to, or rather than, PTHs 45, substrate 32 may use other coupling mechanisms, such as metal or interconnect layers, vias, through silicon vias (TSVs), etc., as persons of ordinary skill in the art understand. In some embodiments, substrate 30 includes a core (not shown in Fig. 1) on or within which coupling mechanisms or interconnects are formed.

In exemplary embodiments, substrate 30 may couple to a circuit carrier, board, or substrate 42. Circuit carrier 42 may be a suitable device to connect physically and couple electrically to circuitry, coupling mechanisms or interconnects, in or on die 32 and/or substrate 30. In exemplary embodiments, circuit carrier 42 may be a printed circuit board (PCB), thick-film substrate, and the like, as persons of ordinary skill in the art understand. Circuit carrier 42 may include a variety of coupling mechanisms or interconnects, such as layers, vias, PTHs, and the like, as desired, depending on factors such as the complexity of the interconnects to be accommodated, available technology, cost, etc.

In exemplary embodiments, substrate 30 is coupled to circuit carrier 42 via coupling mechanism or interconnect 40. Coupling mechanism 40 may constitute solder balls, solder bumps, micro bumps, and the like, as persons of ordinary skill in the art understand.

In addition to substrate 30, circuit carrier 42 may couple electrically (and mechanically, as desired) to a variety of other devices and electrical circuitry (not shown in Fig. 1). Examples include integrated circuits (ICs), interconnect (e.g., edge connectors), discrete devices (both active (e.g., transistors, diodes) and passive (resistors, inductors, capacitors)).

By using one or more of coupling mechanism 40, shielded interconnect 50, bond wires 47 and PTHs 45 (and/or other coupling mechanism in substrate 30), circuitry in die 32 may be coupled to circuitry in substrate 30 and/or circuit carrier 42 and circuitry or device(s) (not shown) included in or on circuit carrier 42. In this manner, circuit carrier and the circuitry included in or on die 32 may provide the functionality of a complete system, sub-system, or block, as desired.

By using die that include circuitry with a wide range and type of circuitry, flexible mechanisms for producing complex systems are provided. The coupling mechanisms (see, for example, coupling mechanisms 40, 47, 45, and 50 in Fig. 1) provide a flexible mechanism for signal and power flow in the device and/or between the device and other devices or circuits.

In some embodiments, the device shown in Fig. 1 may be packaged within a mold or a number of molded sections. Referring to Fig. 1, molded sections 43A, 43B, and 43C encompass or cover or couple various parts or components of the device. More specifically, in the embodiment shown in Fig. 1, molded section 43A encompasses portion(s) or part(s) of shielded interconnects 50. Molded section 43B couples to (e.g., to provide support) or packages a part of substrate 30. Furthermore, molded section 43C covers the top portion of the device, and thus packages or protects bond wires 47 and portion(s) of shielded interconnects 50.

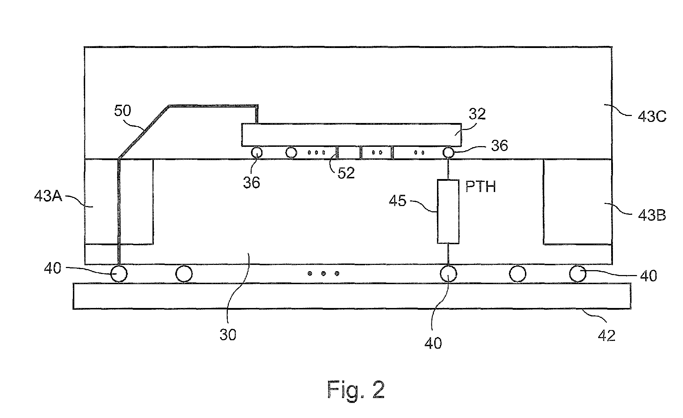

Fig. 2 illustrates another device or package with shielded interconnect according to an exemplary embodiment. Specifically, the device in Fig. 2 includes semiconductor die 32 disposed on or above a substrate 30. The device in Fig. 2 is similar to the device in Fig. 1 but, rather than using bond wires, it uses other coupling mechanisms between die 32 and substrate 30.

More specifically, the device in Fig. 2 may include in substrate 30 and/or die 32 one or more layers of metal or interconnects, vias, TSVs, and/or PTHs, as desired. In addition, the device includes one or more coupling mechanism or interconnect 36 to couple circuitry in die 32 to circuitry in substrate 30.

In exemplary embodiments, coupling mechanism 36 may constitute solder balls, solder bumps, micro bumps, and the like, as persons of ordinary skill in the art understand. Together with PHTs 45, vias, metal or interconnect layers, vias, TSVs, etc., may be used to couple circuitry in die 32 to circuitry in substrate 30. In some embodiments, coupling mechanism 36 may be used to communicate signals and/or distribute power between die 32 and substrate 30.

Similar to the device in Fig. 1, the device in Fig. 2 includes one or more shielded interconnects 50. Shielded interconnects 50 provide a coupling path between circuitry in die 32 and circuitry in substrate 30. As described below in detail, the shielded nature of interconnects 50 provides a number of advantages over coupling mechanism 36 and the like.

Furthermore, the device in Fig. 2 includes one or more shielded interconnects 52. Shielded interconnects 52 also provide a coupling path between circuitry in die 32 and circuitry in substrate 30. Thus, shielded interconnects 50 may be used to communicate signals and/or distribute or route power between die 32 and substrate 30. Shielded interconnects 52 are arranged between die 32 and a face or surface of substrate 30 (the top surface in the embodiment shown in Fig. 2). Because of that arrangement, in exemplary embodiments, shielded interconnects 52 have the same or similar heights as does coupling mechanism 36 (e.g., solder balls).

Although Fig. 2 shows one semiconductor die 32, in some embodiments more than one semiconductor die may be used. For example, in some embodiments, more than one semiconductor die 32 (e.g., 32A, 32B, etc.) may be used. Depending on the respective sizes of the die, circuit complexity, available technology, etc., other arrangements and/or other numbers of die may be used in other embodiments, as desired.

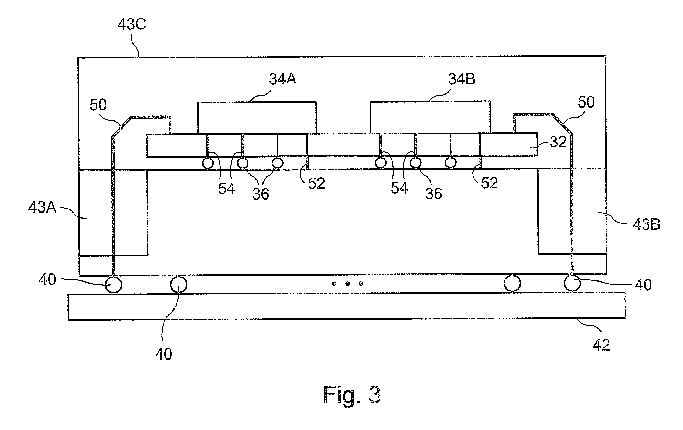

Fig. 3 illustrates another device or package with shielded interconnect according to an exemplary embodiment. The device in Fig. 3 is similar to the device in Fig. 2 but, rather than one die 32 on or above substrate 30, it includes additional die.

Specifically, the device in Fig. 3 includes semiconductor die 32 disposed on or above a substrate 30. In some embodiments, die 32 may constitute a semiconductor die. In other embodiments, die 32 may constitute an interposer, for example, a silicon interposer. As noted above, die 32 may include a variety of circuitry, interconnect or coupling mechanism, etc.

In addition, the device in Fig. 3 includes die 34A and die 34B, disposed above die 32. Generally speaking, semiconductor die 34A-34B may include a wide variety of circuitry and/or devices, as desired. Such circuitry may include analog circuitry, digital circuitry, and mixed-signal circuitry.

As noted above, coupling mechanism 36 provides a way to communicate signals and/or distribute power between die 32 and substrate 30. In addition, shielded interconnects 52 may also provide a coupling path between circuitry in die 32 and circuitry in substrate 30. Thus, shielded interconnects 52 may be used to communicate signals and/or distribute or route power between die 32 and substrate 30.

Die 32 may include a variety of coupling mechanism or interconnects. Examples include one or more PTHs, metal or interconnect layers, vias, through silicon vias (TSVs), etc., as described above. By using one or more coupling mechanisms, signal communication and/or power distribution between circuitry in die 32 and die 34A and/or die 34B may be provided.

Furthermore, die 32 may include one or more shielded interconnects 54. Shielded interconnects 54 also provide a coupling path between circuitry in die 32 and circuitry in die 34A and/or die 34B. Thus, shielded interconnects 54 may be used to communicate signals and/or distribute or route power between die 32 and substrate 30.

In exemplary embodiments, shielded interconnects 54 may be arranged between coupling mechanism 36 and die 34A-34B. Shielded interconnects 54 may be used to communicate signals and/or distribute or route power between substrate 30 and die 34A-34B and/or between die 32 and die 34A-34B, as desired.

Although Fig. 3 shows one die 32 and two die 34A-34B, in some embodiments other numbers of die may be used. For example, in some embodiments, more than two semiconductor die 34 (e.g., 34A-34C, etc.) and/or more than one semiconductor die 32 (e.g., 32A-32B, etc.) may be used. Depending on the respective sizes of the die, circuit complexity, available technology, etc., other arrangements and/or other numbers of die may be used in other embodiments, as desired.

Furthermore, rather than, or in addition to, using shielded interconnects 50 to couple die 32 to substrate 30, shielded interconnects 50 may be used to couple circuitry in die 34A and/or 34B to substrate 30. Depending on the respective sizes of the die, circuit complexity, available technology, type and number of signals, etc., other arrangements and/or other numbers of shielded interconnects 50 may be used in other embodiments, as desired.

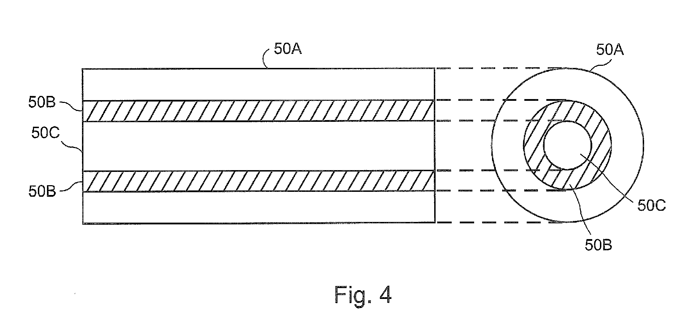

Figs. 4-5 depicts details of shielded interconnects according to exemplary embodiments. The structures shown in Figs. 4-5 may be used to fabricate a variety of shielded interconnects, such as interconnects 50, 52, and 54 (see Figs. 1-3).

Referring to Fig. 4, it illustrates a cross-section of a shielded interconnect or coupling mechanism according to an exemplary embodiment, such as shielded interconnect 50. The shielded interconnect includes a conductor 50A, dielectric 50B, and conductor 50C.

Conductor 50A generally surrounds and thus shields conductor 50C. In some embodiments, conductor 50A may completely surround conductor 50C. In other embodiments, conductor 50A may not completely surround conductor 50C, i.e., conductor 50A may partially surround conductor 50C. The choice depends on a number of factors, such as the degree of shielding or isolation desired, type of materials and/or technology available, cost, amount of available space, etc., as persons of ordinary skill in the art understand.

Dielectric 50B is disposed between conductor 50A and conductor 50C. Depending on the geometry of the shielded interconnect, described above, dielectric 50B may or may not completely surround conductor 50C. A variety of dielectric materials may be used, such as silicon dioxide. The choice of dielectric depends on a number of factors, such as the degree of shielding or isolation desired, type of materials and/or technology available, cost, amount of available space, etc., as persons of ordinary skill in the art understand.

The shielded interconnect may be fabricated by first disposing conductor 50C in a desired location and orientation. Next, dielectric 50B may be fabricated. In some embodiments, dielectric 50B may be fabricated by depositing dielectric material. In other embodiments, dielectric 50B may be fabricated by coating conductor 50C with the dielectric material.

Dielectric 50B may have a desired thickness. The thickness of dielectric 50B affects various characteristics of the shielded interconnect, as persons of ordinary skill in the art understand. Examples include velocity of propagation, breakdown voltage, capacitance per unit length, level of electrical isolation between conductors 50A and 50C, etc. Thus, dielectric 50B may be fabricated with a thickness that meets desired specifications for a given implementation.

In some embodiments, the shielded interconnect may be asymmetrical. For example, conductor 50C may not be centrally or symmetrically disposed with respect to conductor 50A. In other embodiments, conductor 50C may be centrally or symmetrically disposed with respect to conductor 50A, thus producing a coaxial structure or interconnect.

The various components of the shielded interconnect may have a desired geometry or cross-section. In the example shown in Fig. 4, conductors 50A and 50C and dielectric 50B have circular or annular cross-sections. The resulting shielded interconnect therefore has a circular or annular shape or cross-section. In other embodiments, conductors 50A and 50C and dielectric 50B and/or the shielded interconnect may have other shapes, such as polygons (with three or more sides), ellipses, etc. Examples shapes include triangular, square, rectangular, etc.

In exemplary embodiments, conductors 50A and 50C may constitute copper (e.g., copper pillars or other structures, as persons of ordinary skill in the art understand), aluminum, or other desired conductor or metal. The choice of material depends on a number of factors, such as the desired conductivity, type of materials and/or technology available, cost, amount of available space, etc., as persons of ordinary skill in the art understand.

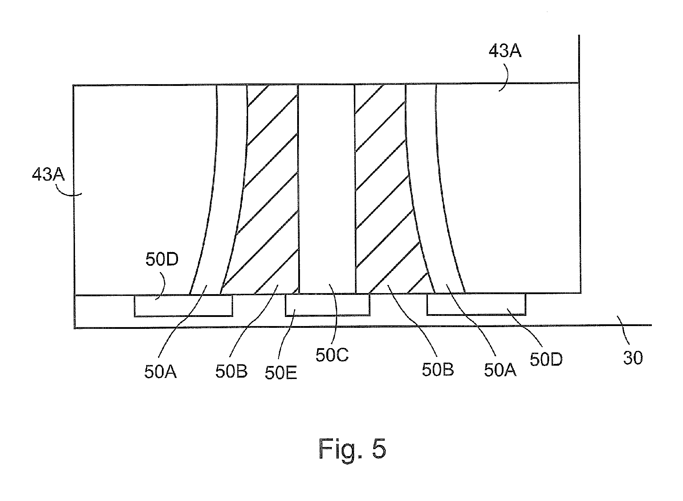

Fig. 5 shows a cross-section of a shielded interconnect or coupling mechanism according to an exemplary embodiment. More specifically, Fig. 5 shows the details of shielded interconnect 50 fabricated to couple to substrate 30 (although similar structures and techniques may be used in other embodiments, such as those shown in Figs. 1-3).

Referring to Fig. 5, substrate 30 (or other structure or component, such as die 32, die 34A or 34B, etc.) has a number of landing pads fabricated to couple to various components or parts of the shielded interconnect. Specifically, landing pad 50D couples to conductor 50A, and landing pad 50E couples to conductor 50C. Landing pads 50D and 50E may be fabricated using a desired technique, as persons of ordinary skill in the art understand.

Fabrication of the shielded interconnect proceeds by fabricating conductor 50C. As noted, conductor 50C couples to landing pad 50E. Through landing pad 50E, conductor 50C may couple electrically to other structures or circuitry (not shown), as desired, and as described above.

Next, dielectric 50B is fabricated. As noted above, dielectric 50B may be deposited, applied as a coating to conductor 50C, etc. Once dielectric 50B has been fabricated, conductor 50A is fabricated. Molded section 50A may then be added as desired, and as described above.

Shielded interconnects according to various embodiments may be used in a variety of applications. Generally speaking, shielded interconnects according to various embodiments may be used to provide electrical coupling between various devices, circuits, blocks, and the like, in devices or electronic assemblies.

In one application, as noted above, shielded interconnects may be used to communicate signals, such as in analog, digital, or mixed-signal circuitry. In some embodiments, shielded interconnects may be used to communicate signals (e.g., data or information, control, status, etc.) in high speed serial interface (HSSI) circuitry, such as transmitters, receivers, or transceivers. In other embodiments, shielded interconnects may be used to communicate signals (e.g., data or information, control, status, etc.) in general purpose input/output (GPIO) circuitry, such as input, output, or input/output (I/O) circuitry.

In another application, as noted above, shielded interconnects may be used to provide power to various circuits. In some embodiments, shielded interconnects may be used to distribute power, or provide power to various circuits, blocks, sub-blocks, systems, sub-systems, etc. In other embodiments, shielded interconnects may be used as part of a power distribution network (PDN).

As noted above, shielded interconnects provide a number of advantages and benefits. They include: (a) improved speed of operation (e.g., 50 to 100 gigabits per second in HSSI circuitry); (b) improved group delay (relatively flat group delay, which is desirable in some signal transmission applications); (c) improved signal transmission and lower signal reflection (e.g., in high-speed applications, where signal paths act like transmission lines, rather than lumped networks); (d) improved isolation, such as galvanic isolation; (e) improved leakage (e.g., lower leakage in applications where some of the circuitry has relatively high impedance, and/or in low-power applications); (f) improved interference mitigation (e.g., because of shielding of signals or interconnects that are relatively sensitive to noise or interference); and (g) improved resistive damping (e.g., in power distribution or power network applications).

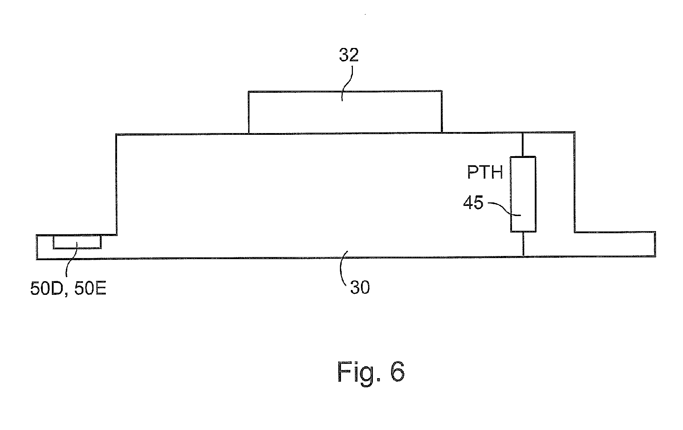

As noted above, electronic assembles or devices using shielded interconnects may be fabricated in a number of ways. Figs. 6-8 illustrate various steps in fabrication of the device in Fig. 1. Fig. 6 depicts a partly fabricated device according to an exemplary embodiment. Substrate 30 may be processed to fabricate landing pads 50D and 50E. In addition, various interconnect, such as PTHs 45, vias, TSVs, metal layers, etc., may be fabricated, as noted above. Die 32 may be disposed or mounted on or above substrate 30.

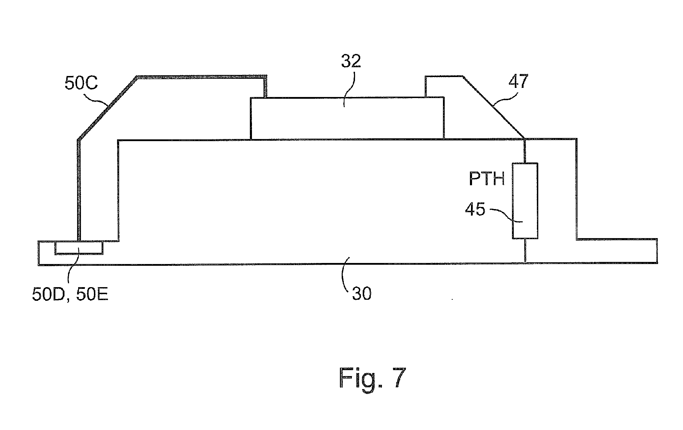

Fig. 7 illustrates further processing or fabrication of the device of Fig. 6. Referring to Fig. 7, one or more bond wires 47 may be fabricated. (In other embodiments, other coupling mechanisms may be fabricated, or may have been fabricated prior to the fabrication of the shielded interconnect(s).

Fabrication of shielded interconnects may be performed in a number of ways, for example, as described above in connection with Figs. 4-5. Referring to Fig. 7, one or more shielded interconnects may be fabricated. Specifically, as an example, Fig. 7 shows the fabrication of conductor 50C for one shielded interconnect. In addition to conductor(s) 50C, dielectric 50B may be fabricated, for example, by coating conductor(s) 50C.

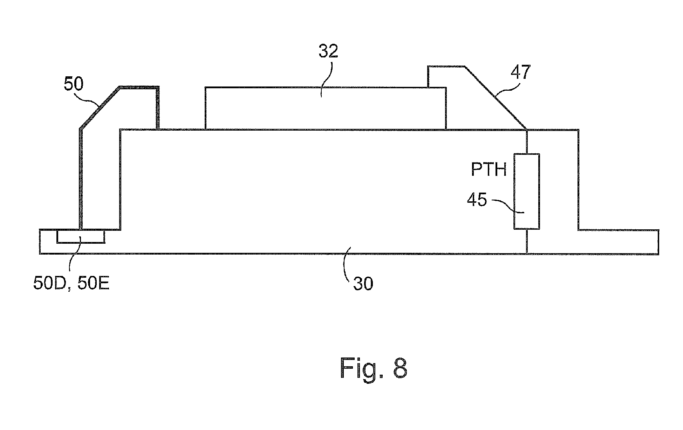

Fig. 8 depicts further processing or fabrication of the device of Fig. 7. Referring to Fig. 8, conductor(s) 50A (not shown explicitly) have been fabricated, as described above. Fig. 8 shows one completed shielded interconnect 50 (although more than one shielded interconnect 50 may be fabricated, as desired, and as noted above).

Note that to facilitate clarity of presentation, partial fabrication steps are described above. Other fabrication steps may be used to produce other features of stacked semiconductor devices according to various embodiments. For example, the fabrication of coupling mechanisms 36, 40, 45, and 47 (as well as metal or interconnect layers, vias, TSVs, etc.) may be performed using techniques known to persons of ordinary skill in the art (e.g., during fabrication of substrate 30 or a core of substrate 30, etc.).

As persons of ordinary skill in the art understand, techniques, materials, and structures similar to those shown in Figs. 4-8 may be used to fabricate other electronic assembles or devices, such as those shown in the exemplary embodiments of Figs. 2-3. In addition to the exemplary embodiments shown and described, other arrangements and packaging schemes may be used, as desired. The choice of such arrangements and packaging schemes depends on the design and performance specifications for the device, cost, complexity, available technology, etc., as persons of ordinary skill in the art understand.

As noted above, the die in devices or electronic assemblies employing shielded interconnects may include a wide variety of circuitry. In some embodiments, one or more of the die may include field-programmable gate array (FPGA) circuitry. One or more shielded interconnects may be used to couple various circuits in such devices or electronic assemblies to one another, for example, one or more FPGA circuits (e.g., fabricated in or on one die) to other circuits (e.g., circuitry fabricated in or on another die).

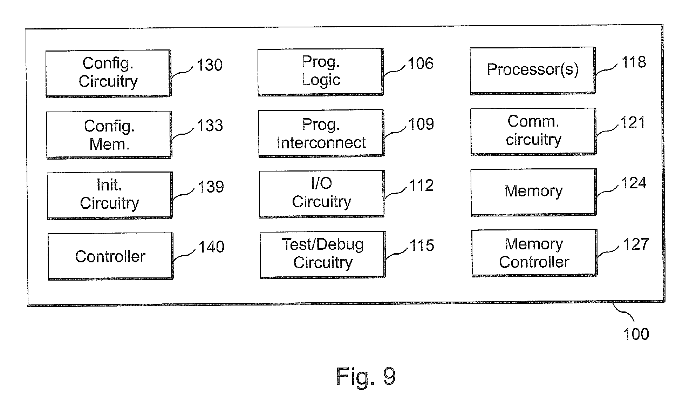

Fig. 9 illustrates a general block diagram of an FPGA 100 that may be used in whole or in part (e.g., some of the circuits or blocks of circuits) in such embodiments. FPGA 100 includes configuration circuitry 130, configuration memory (CRAM) 133, controller 140, programmable logic 106, programmable interconnect 109, and I/O circuitry 112.

In addition, FPGA 100 may include test/debug circuitry 115, one or more processors 118, one or more communication circuitry 121, one or more memories 124, one or more controllers 127, and initialization circuit 139, as desired. In some embodiments, FPGA 100 may also include one or more voltage regulators or power supply circuits (not shown).

Note that the figure shows a general block diagram of FPGA 100. Thus, FPGA 100 may include other blocks and circuitry, as persons of ordinary skill in the art understand. Examples of such circuitry include clock generation and distribution circuits, and the like. Furthermore, FPGA 100 may include analog circuitry, other digital circuitry, and/or mixed-signal circuitry, fuses, anti-fuses, and the like, as desired.

Programmable logic 106 includes blocks of configurable or programmable logic circuitry, such as look-up tables (LUTs), product-term logic, pass gates, multiplexers (MUXs), logic gates, registers, memory, and the like. Programmable interconnect 109 couples to programmable logic 106 and provides configurable interconnects (coupling mechanisms) between various blocks within programmable logic 106 and other circuitry within or outside FPGA 100 (for example, by using pass gates and/or MUXs). In some embodiments, programmable logic 106 and/or programmable interconnect 109 may include fuses and/or anti-fuses to provide additional flexibility or programmability.

Initialization circuit 139 may cause the performance of various functions at reset or power-up of FPGA 100. At or after power-up, FPGA 100 obtains configuration information, typically from an external device. Based on the configuration information, various blocks or devices within the FPGA core or fabric, or other blocks or resources in FPGA 100, are configured or programmed. Examples include programmable logic 106 and programmable interconnect 109. Part of the circuitry in programmable interconnect 109 may be used to realize interconnect 138 in Fig. 8, i.e., one or more interconnects with other die in a stacked-die device.

I/O circuitry 112 may constitute a wide variety of I/O devices or circuits. I/O circuitry 112 may couple to various parts of FPGA 100, for example, programmable logic 106 and programmable interconnect 109. I/O circuitry 112 provides a mechanism and circuitry for various blocks within FPGA 100 to communicate with external circuitry or devices, such as other die in a device, as desired. For example, in exemplary embodiments, I/O circuitry 112 may include, or may be coupled to, shielded interconnect (not shown) to couple various circuits in FPGA 100 to other circuits in an electronic assembly or device, as desired, and as described above.

Referring to Fig. 8, test/debug circuitry 115 facilitates the testing and troubleshooting of various blocks and circuits within FPGA 100. Test/debug circuitry 115 may include a variety of blocks or circuits known to persons of ordinary skill in the art. For example, test/debug circuitry 115 may include circuits for performing tests after FPGA 100 powers up or resets, as desired. Test/debug circuitry 115 may also include coding and parity circuits, as desired.

FPGA 100 may include one or more processors 118. Processor 118 may couple to other blocks and circuits within FPGA 100. Processor 118 may receive data and information from circuits within or external to FPGA 100 and process the information in a wide variety of ways, as persons skilled in the art understand. One or more of processor(s) 118 may constitute a digital signal processor (DSP). DSPs allow performing a wide variety of signal processing tasks, such as compression, decompression, audio processing, video processing, filtering, and the like, as desired. Processor(s) 118 may operate in cooperation with circuitry included in other die within a stacked-die device, for example, application specific IC (ASIC) circuitry included in a die.

FPGA 100 may also include one or more communication circuit(s) 121. Communication circuit(s) 121 may facilitate data and information exchange between various circuits within FPGA 100 and circuits external to FPGA 100, as persons of ordinary skill in the art understand. Examples of communication circuit 121 include transceivers, network interface circuits, etc., such as HSSI circuits, described above.

FPGA 100 may further include one or more memories 124 and one or more memory controller(s) 127. Memory 124 allows the storage of various data and information (such as user-data, intermediate results, calculation results, etc.) within FPGA 100. Memory 124 may have a granular or block form, as desired. Similar to processor(s) 118, memory 124 may operate in cooperation with circuitry included in other die within a stacked-die device, for example, ASIC circuitry included in a die.

Memory controller 127 allows interfacing to, and controlling the operation and various functions of, circuitry outside the FPGA. For example, memory controller 127 may interface to and control an external synchronous dynamic random access memory (SDRAM). The external SDRAM may be located in other die within a stacked-die device, for example, ASIC circuitry included in a die.

By using the various resources of FPGA 100, together with circuitry included in other die in a stacked die device, a wide variety of functions, such as entire systems, may be realized. Such systems may operate in cooperation with (or include) sensors, transducers, input/output devices (e.g., displays, keyboards), and the like. Furthermore, such systems may produce, process, or provide a wide variety of signals and types of signals, such as analog, digital, and mixed-signal.

As persons of ordinary skill in the art understand, one may apply the disclosed concepts effectively to various types of circuitry or die. Examples described in this document constitute merely illustrative applications, and are not intended to limit the application of the disclosed concepts to other types of devices or die by making appropriate modifications. Those modifications fall within the knowledge and level of skill of persons of ordinary skill in the art. For example, rather than FPGA circuitry realized in a semiconductor die, other types of circuitry, known for instance as programmable logic device (PLD), complex PLD (CPLD), and the like, may be used.

In some embodiments, circuitry implemented using the stacked die may provide different or complementary functionality. For example, one die (e.g., die 32 in Fig. 3) may include application specific IC (ASIC) circuitry, system on a chip (SoC), and the like, whereas another die (e.g., die 34A and/or die 34B in Fig. 3) may include FPGA circuitry. In this manner, the ASIC (or SoC) can provide some parts of the overall system functions with lower area and power dissipation overhead (albeit with less flexibility), whereas the FPGA provide other parts of the overall system function with increased flexibility, programmability or configurability.

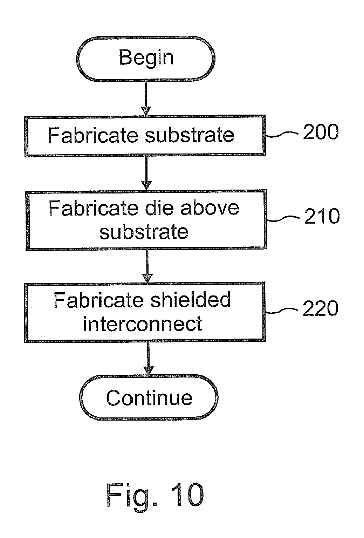

As noted, one aspect of the disclosure relates to method of fabricating devices and interconnects. Fig. 10 illustrates a flow diagram for a method of fabricating a device according to an exemplary embodiment. At 200, a substrate is fabricated that may include various circuitry, as described above. At 210, a first die is fabricated above the substrate. The first die may also include various circuitry, as described above. At 220, a shielded interconnect is fabricated. The shielded interconnect couples the circuitry in the substrate to the circuitry in the first die.

In some embodiments, the shielded interconnect constitutes a coaxial interconnect. In some embodiments, a second shielded interconnect is fabricated between the substrate and the first die. The second shielded interconnect couples circuitry in the substrate to circuitry in the first die. In some embodiments, a second die is fabricated above the first die. The second die may include various circuitry, as described above. Also, a third shielded interconnect is fabricated between the two die, where the third shielded interconnect couples circuitry in the first die to circuitry in the second die. In some embodiments, the second and third shielded interconnects constitute coaxial interconnects.

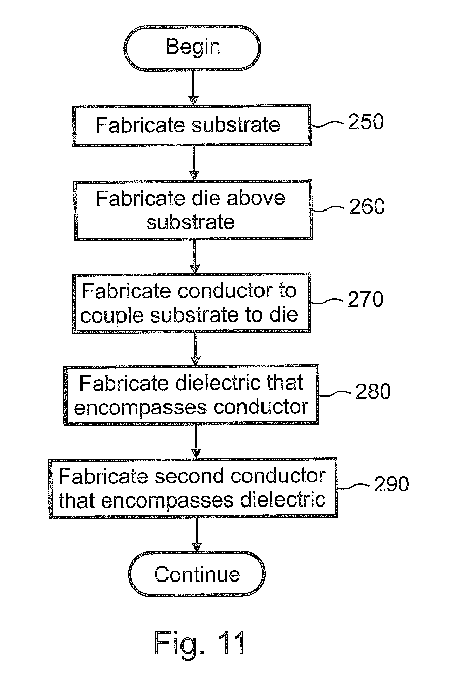

Fig. 11 depicts a flow diagram for a method of fabricating a shielded interconnect in an electronic assembly according to an exemplary embodiment. At 250, a substrate is fabricated for the electronic assembly. At 260, a first die is fabricated above the substrate. At 270, a first conductor is fabricated to couple the substrate to the first die. At 280, a dielectric is fabricated that encompasses the first conductor. At 290, a second conductor is fabricated. The second conductor encompasses the dielectric. The second conductor couples the substrate to the first die.

In some embodiments, fabricating the substrate for the electronic assembly includes fabricating first and second landing pads. Furthermore, fabricating the first conductor includes coupling the first conductor to the first landing pad, and fabricating the second conductor includes coupling the second conductor to the first landing pad. In some embodiments, fabricating the dielectric includes coating the first conductor with dielectric.

Referring to the figures, persons of ordinary skill in the art will note that the various blocks shown might depict mainly the conceptual functions and signal flow. The actual circuit implementation might or might not contain separately identifiable hardware for the various functional blocks and might or might not use the particular circuitry shown. For example, one may combine the functionality of various blocks into one circuit block, as desired. Furthermore, one may realize the functionality of a single block in several circuit blocks, as desired. The choice of circuit implementation depends on various factors, such as particular design and performance specifications for a given implementation. Other modifications and alternative embodiments in addition to those described here will be apparent to persons of ordinary skill in the art. Accordingly, this description teaches those skilled in the art the manner of carrying out the disclosed concepts, and is to be construed as illustrative only.

An additional embodiment 1 relates to an apparatus comprising a substrate comprising electronic circuitry; a first die comprising electronic circuitry, the first die disposed above the substrate; and a first shielded interconnect to couple electronic circuitry in the substrate to electronic circuitry in the first die.

According to an additional embodiment 2, in the apparatus according to additional embodiment 1, the first shielded interconnect couples to a plurality of landing pads fabricated in the substrate.

According to an additional embodiment 3, in the apparatus according to additional embodiment 1, the first shielded interconnect comprises a first conductor, a dielectric encompassing the first conductor, and a second conductor encompassing the dielectric.

According to an additional embodiment 4, in the apparatus according to additional embodiment 3, the first and second conductors comprise copper.

According to an additional embodiment 5, the apparatus according to additional embodiment 1 further comprises a first molded section to encompass at least a part of the first shielded interconnect.

According to an additional embodiment 6, the apparatus according to additional embodiment 5 further comprises a second molded section to encompass at least a part of the substrate.

According to an additional embodiment 7, the apparatus according to additional embodiment 1 further comprises a second shielded interconnect to couple electronic circuitry in the substrate to electronic circuitry in the first die, the second shielded interconnect disposed above the substrate and below the first die.

According to an additional embodiment 8, the apparatus according to additional embodiment 5 further comprises a second die comprising electronic circuitry; and a third shielded interconnect to couple electronic circuitry in the first die to electronic circuitry in the second die.

According to an additional embodiment 9, in the apparatus according to additional embodiment 1, the second shielded interconnect (a) communicates a signal between the substrate and the first die or (b) distributes power between the substrate and the first die.

According to an additional embodiment 10, in the apparatus according to additional embodiment 5, the first shielded interconnect (a) communicates a signal between the substrate and the first die or (b) distributes power between the substrate and the first die.

According to an additional embodiment 11, in the apparatus according to additional embodiment 8, the first shielded interconnect (a) communicates a signals between the first and second die or (b) distributes power between the first and second die.

According to an additional embodiment 12, in the apparatus according to additional embodiment 8, wherein at least one of the first and second die includes field-programmable gate array (FPGA) circuitry.

An additional embodiment 13 relates to a method of fabricating a device. The method comprises fabricating a substrate, the substrate comprising circuitry; fabricating a first die above the substrate, the first die comprising circuitry; and fabricating a first shielded interconnect to couple circuitry in the substrate to circuitry in the first die.

According to an additional embodiment 14, in the method according to additional embodiment 13, the first shielded interconnect comprises a coaxial interconnect.

According to an additional embodiment 15, the method according to additional embodiment 13 further comprises fabricating a second shielded interconnect between the substrate and the first die, the second shielded interconnect to couple circuitry in the substrate to circuitry in the first die.

According to an additional embodiment 16, the method according to additional embodiment 15 further comprises fabricating a second die above the first die, the second die comprising circuitry; and fabricating a third shielded interconnect between the first and second die, the third shielded interconnect to couple circuitry in the first die to circuitry in the second die.

According to an additional embodiment 17, in the method according to additional embodiment 16, the second and third shielded interconnects comprise coaxial interconnects.

An additional embodiment 18 relates to another method of fabricating a shielded interconnect in an electronic assembly. The method comprises fabricating a substrate for the electronic assembly; fabricating a first die above the substrate; fabricating a first conductor to couple the substrate to the first die; fabricating a dielectric encompassing the first conductor; and fabricating a second conductor encompassing the dielectric, the second conductor to couple the substrate to the first die.

According to an additional embodiment 19, in the method according to additional embodiment 18, fabricating the substrate for the electronic assembly further comprises fabricating first and second landing pads, wherein fabricating the first conductor further comprises coupling the first conductor to the first landing pad, and wherein fabricating the second conductor further comprises coupling the second conductor to the first landing pad.

According to an additional embodiment 20, in the method according to additional embodiment 18, fabricating the dielectric further comprises coating the first conductor with dielectric.

The forms and embodiments shown and described should be taken as illustrative embodiments. Persons skilled in the art may make various changes in the shape, size and arrangement of parts without departing from the scope of the disclosed concepts in this document. For example, persons skilled in the art may substitute equivalent elements for the elements illustrated and described here. Moreover, persons skilled in the art may use certain features of the disclosed concepts independently of the use of other features.

## Claims

1. An apparatus comprising:
a substrate comprising electronic circuitry;
a first die comprising electronic circuitry, the first die disposed above the substrate; and
a first shielded interconnect to couple electronic circuitry in the substrate to electronic circuitry in the first die.

2. The apparatus according to claim 1, wherein the first shielded interconnect couples to a plurality of landing pads fabricated in the substrate.

3. The apparatus according to claim 1 or 2, wherein the first shielded interconnect comprises a first conductor, a dielectric encompassing the first conductor, and a second conductor encompassing the dielectric.

4. The apparatus according to one of claims 1 to 3, further comprising a first molded section to encompass at least a part of the first shielded interconnect, and.

5. The apparatus according to claim 4, further comprising a second molded section to encompass at least a part of the substrate.

6. The apparatus according to one of claims 1 to 5, further comprising a second shielded interconnect to couple electronic circuitry in the substrate to electronic circuitry in the first die, the second shielded interconnect disposed above the substrate and below the first die.

7. The apparatus according to one of claims 1 to 4, further comprising:
a second die comprising electronic circuitry;
a third shielded interconnect to couple electronic circuitry in the first die to electronic circuitry in the second die.

8. The apparatus according to claim 7, wherein at least one of the first and second die includes field-programmable gate array (FPGA) circuitry.

9. The apparatus according to one of claims 1 to 8, wherein the second shielded interconnect communicates a signal between the substrate and the first die or distributes power between the substrate and the first die.

10. The apparatus according to one of claims 1 to 9, wherein the first shielded interconnect communicates a signal between the substrate and the first die or distributes power between the substrate and the first die.

11. The apparatus according to one of claims 1 to 9, wherein the first shielded interconnect communicates a signals between the first and second die or distributes power between the first and second die.

12. A method of fabricating a device, the method comprising the steps of:
fabricating a substrate, the substrate comprising circuitry;
fabricating a first die above the substrate, the first die comprising circuitry; and
fabricating a first shielded interconnect to couple circuitry in the substrate to circuitry in the first die.

13. The method according to claim 12, wherein the first shielded interconnect comprises a coaxial interconnect.

14. The method according to claim 12 or 13, further comprising fabricating a second shielded interconnect between the substrate and the first die, the second shielded interconnect to couple circuitry in the substrate to circuitry in the first die.

15. The method according to claim 14, further comprising:
fabricating a second die above the first die, the second die comprising circuitry; and
fabricating a third shielded interconnect between the first and second die, the third shielded interconnect to couple circuitry in the first die to circuitry in the second die.

16. The method according to claim 15, wherein the second and third shielded interconnects comprise coaxial interconnects.
